# EUROPEAN PATENT APPLICATION

(11) **EP 2 322 853 A2**
(43) Date of publication of application: **18.05.2011**
(21) Application number: 11153366.7
(22) Date of filing: 27.09.2005
(51) Int. Cl.: F21V 29/00, H05K 1/18, F21K 99/00, F21Y 101/02

(54) **Power led type lighting or light signaling device**

(62) Divisional of application: 05802256.7
(71) Applicant: Immobiliare Eder S.R.L., 42100 Reggio Emilia RE (IT)
(72) Inventor: Cucchi, Mauro, 43015, Noceto PR (IT); Incerti, Edda, 42100, REGGIO EMILIA RE (IT)
(74) Representative: Bonatto, Marco

(57) **Abstract**

The device is of the type comprising: - a laminate (6, 30, 38, 54, 57, 60, 64, 79, 91, 109, 127) with a printed circuit; - at least one power LED (1, 16, 56, 59, 62, 63, 78, 89, 90, 107, 108, 125, 126) comprising a main body (4, 144) with two electrical terminals (3, 35, 44, 47) protruding from this, connected to such printed circuit, and with a slug (5, 20, 29, 37,49, 53) on one side acting as heat sink for dispersion of heat; - a metallic body (9, 22, 33, 42, 67, 82, 96, 114, 132) where such slug is connected indirectly in order to permit such dispersion of heat, such metallic body having a flat face parallel and opposed to such laminate and on which the laminate is fastened; and is characterized by the fact that: - the LED is not outside the laminate of the printed circuit but is inserted in the same through a hole (7, 31, 39, 65, 80, 92, 93, 110, 111, 128, 129) present in the printed circuit; - the aforesaid face is covered, at least at a position opposite to the aforesaid LED, by a thin layer (8, 32, 41, 66, 81, 94, 95, 112, 113, 130, 131) of insulating material in contact with such slug, to assure not only electrical insulation but also thermal coupling with the slug; - the edges of such hole, pressing on the body of the LED, maintain the aforesaid slug in contact with such thin layer of insulating material.

## Description

The invention refers to a lighting or light signaling device that uses power light emitting diodes (LEDs) to replace other types of equivalent devices belonging to the field of monochrome/polychrome lighting/signaling systems.

### BACKGROUND

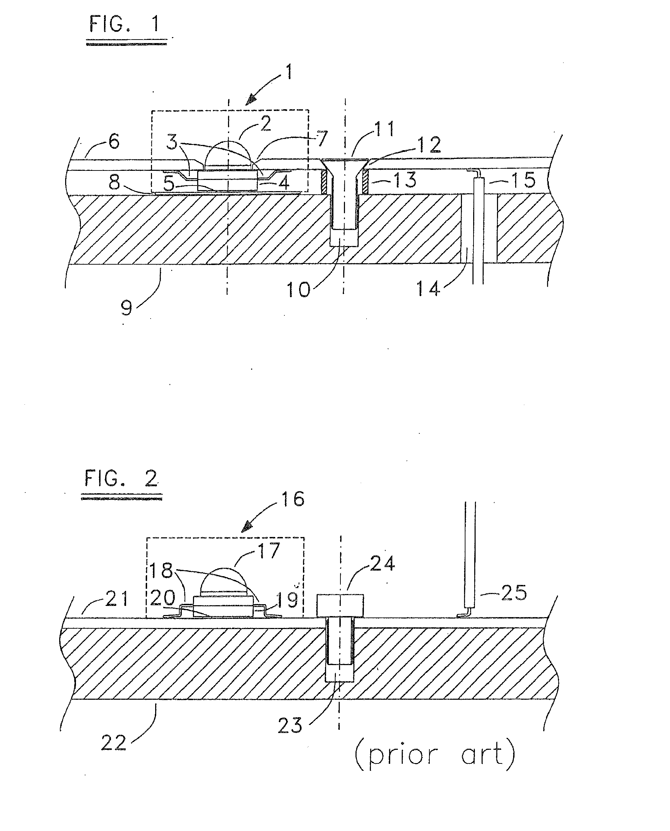

In their more general form, all present power LED assembly systems. (see fig. 2 referring to the previous state of the art) involve use of a LED semiconductor 16 consisting of a primary lens 17 fitted at the top to a main body 19 with two leads 18 exiting from the side and, at the bottom, a slug 20 designed to guarantee connection (even if not directly) to a metallic mass 22 usually made of aluminum and designed to disperse heat.

It should be noted that any type of power LED semiconductor available on the market used in current assembly systems can be used even in the assembly system of present invention. Commercially-available power LEDs differ as refers to the shape of the primary lens, of the main body (which may be cylindrical or parallelepiped), the shape and position of the leads that may be at opposite ends or on the same side of the main body, the shape of the slug for connection to the heat sink and its position, which may be centered or to the side and, in some cases, partly protruding from the profile of the main body.

For the sake of clarity, in the description and figures below, reference will be made principally to power LED semiconductors belonging to the Luxeon Emifter^{®} family of devices of Lumileds Lighting, a leading international manufacturer, but what is herewith described/illustrated is also applicable to other commercially-available power LED models of other manufacturers.

A further characteristic of the known systems used at the moment is fastening of the LED semiconductor 16 to a particular printed circuit 21 (fastened to the heat dispersion plate 22 with the screw 24 tightened in the threaded hole 23) consisting of a laminate fitted inside with a special, expensive additional thermal substrate (not shown). Such substrate is inserted between two layers of metal (not shown), one made of copper where the electrical interconnections (including that to the drive power wire 25) and the contact pad for the slug 20 are obtained, and a thicker one, usually made of aluminum, for connection to the heat dispersion system 22, generally made of the same material.

The thermal substrate inside laminate 21 serves a double purpose, i.e. electrical insulation between the thin metal layer of copper and the thicker layer of aluminum or of other material and, at the same time, maximization of heat transfer between these two metal layers.

This characterization is necessary due to the particular conditions in which power LEDs must operate, i.e. with the slug 20 electrically insulated from other slugs of different devices and also from electrical terminals or metal structures affected by or which may be affected by electrical voltages.

US2005/0024834 discloses a lighting or signaling device having the features according to the preamble of claim 1.

The device shown in Figures 3A, 4 of D1 comprises four continuous layers stacked together:
an overlay layer 62, a printed wiring board 42 (PWB), a thermal layer 48 and a heat sink 46. The pack of these four layers is tightened through a plurality of screws, and each LED 24 is supposed to be consequently pressed against the thermal layer 48 so as to ensure a good thermal coupling with such layer and the heat sink 46.

However the tolerances of the different continuous layers and their different thermal expansion coefficient make it actually difficult to adjust precisely the pressure applied by the layers on the different LEDs 24 and maintain it -as well as its thermal coupling with the thermal layer 48 and the heat sink 46- constant over the time.

### OBJECTS

The main purpose of this invention is therefore to promote improved performance of the power LEDs as regards functionality and reliability, compared with current assemblying systems. This by realizing a device that foresees a power LED assemblying system, alternative to the known systems, in order to reduce the total internal thermal resistance between the internal junction and the ambient air with a consequent improvement of operation efficiency and reduction of overall assembly costs, together with other advantages described and illustrated below.

Other advantages of the invention include the fact that it is suitable for small volume production with manual soldering and also for surface assemblying and that the delicate, expensive primary lenses installed on the power LEDs are protected during the soldering steps.

### SUMMARY OF THE INVENTION

These purposes and advantages are all achieved by present invention as characterized by the claims set forth below.

According to a particular embodiment, the power led lighting or light signaling device according to the invention comprises:
- a laminate (6, 30, 38, 54, 57, 60, 64, 79, 91, 109, 127) with a printed circuit;
- at least one power LED (1 , 16, 56, 59, 62, 63, 78, 89, 90, 107, 108, 125, 126) comprising a main body (4, 144) with two electrical terminals (3, 35, 44, 47) protruding from this, connected to such printed circuit, and with a slug (5, 20, 29, 37,49, 53) on one side acting as heat sink for dispersion of heat;
- a metallic body (9, 22, 33, 42, 67, 82, 96, 114, 132) where such slug is connected indirectly in order to permit such dispersion of heat, such metallic body having a flat face parallel and opposed to such laminate and on which the laminate is fastened;
   and is characterized by the fact that:
- the LED is not outside the laminate of the printed circuit but is inserted in the same through a hole (7, 31, 39, 65, 80, 92, 93, 110, 111, 128, 129) present in the printed circuit;
- the aforesaid face is covered, at least at a position opposite to the aforesaid LED, by a thin layer (8, 32, 41, 66, 81 , 94, 95, 112, 113, 130, 131) of insulating material in contact with such slug, to assure not only electrical insulation but also thermal coupling with the slug;
- the edges of such hole, pressing on the body of the LED, maintain the aforesaid slug in contact with such thin layer of insulating material.

According to a particular embodiment, the power led lighting or light signaling device according to the invention is characterized by the fact that the material forming the aforesaid thin layer of insulating material is a silicone material.

According to a particular embodiment, the power led lighting or light signaling device according to the invention is characterized by the fact that the aforesaid edges of such hole press on the body of the LED via a washer (40).

According to a particular embodiment, the power led lighting or light signaling device according to the invention is characterized by the fact that the laminate with the printed circuit is fastened to the aforesaid flat face using at least a screw (11) and that at least a means of spacing (13) is inserted between the laminate and the same face in order to assure positioning of the laminate at pre-established distance from this.

According to a particular embodiment, the power led lighting or light signaling device according to the invention is characterized by the fact that the aforesaid flat face forms the bottom of a recess (87) realized in said metallic body.

According to a particular embodiment, the power led lighting or light signaling device according to the invention is characterized by the fact that a step (88) in the walls of such recess is used as the aforesaid means of spacing.

According to a particular embodiment, the power led lighting or light signaling device according to the invention is characterized by the fact that a protrusion (139) on the bottom of such recess is used as aforesaid means of spacing.

According to a particular embodiment, the power led lighting or light signaling device according to the invention is characterized by the fact that, in an intermediate section of the two aforesaid terminals of the power LED, there is a fold such as to permit connection of the end of each lead with the printed circuit.

According to a particular embodiment, the power led lighting or light signaling device according to the invention is of the type comprising:
- a laminate (146, 162, 178, 192, 206, 218, 225, 226) with a printed circuit;
- at least one power LED (141, 157, 173, 187, 201) with a main body (144) and two electrical terminals (143,159,175, 189, 203, 215, 222) protruding from this, of the flat and rigid type, connected to a such printed circuit, and with a slug (145, 161, 177, 191, 205, 217, 224) on one side, designed to act as heat sink for dispersion of heat;
- a metallic body (148, 164, 180, 194, 208, 220, 228) to which such slug is connected indirectly in order to permit such heat dispersion, such metallic body having a flat face parallel to and opposite to such laminate and to which such laminate is fastened; characterized by the fact that:
- the LED is not outside the laminate with the printed circuit but is inserted in this through a hole present in the same;
- the aforesaid face is covered, at least at a position opposite to the aforesaid LED, by a thin layer (147, 163, 179, 193 207, 219, 227) of insulating material in contact with such slug, to assure thermal coupling with the same slug and also electrical insulation;
- the edges of such hole, pressing on the terminals of the LED, maintain the aforesaid slug in contact with such thin layer of insulating material.

In a particular embodiment of the invention, the aforesaid thin layer of insulating material can be applied on the top of a protrusion (156,172,181) present in such flat face.

### DRAWINGS

The characteristics and advantages of this invention are highlighted more effectively in the following description of preferred embodiments, all based on the same inventive principle, only indicated as not restrictive examples, and illustrated in the attached figures where:
figure 1 is a partial section view of a first preferred embodiment of the invention showing the assembling features of a power LED and of a printed circuit;
figure 2 is a partial section view, showing the assembling features of a power LED and of a printed circuit according to the current state of the art;
figure 3A shows a detail of fig. 1.
figure 3B shows a variant of the assemblying features of Fig.3A;
figure 4A is a top view of a typical power LED.
figure 4B is a side view of a typical power LED.
figure 4C is a side view of a typical power LED after additional preshaping of the leads.
figure 5 is a top view of a 1st device implementing the embodiment of Fig.1;
figure 6 is a top view of a 2nd device implementing the embodiment of Fig.1;
figure 7 is a top view of a 3rd device implementing the embodiment of Fig.1;
figure 8 is a partial section view of a 4th device implementing the embodiment of Fig.1;
figure 9 is a partial section view of a variant of the device of Fig.8;
figure 10 shows a partial section view of a 5th device implementing the embodiment of Fig.1;
figure 11 shows a partial section view of a 6th device implementing the embodiment of Fig.1;
figure 12 shows a partial section view of a 7th device implementing a variant of the embodiment of Fig.1;
figures 13, 14, 15, 16, 17, 18, 19 show a partial section view of preferred embodiments of the invention using power LEDs of the type with non-folding leads aligned with the slug;
figures 20, 21 are a partial cross-section view and a side view of the device of Fig.7 intended to permit illumination of an manufactured item transparent to light.

### PREFERRED EMBODIMENTS

In the above figures, the numbers have the following meaning:
- 1, 16, 56, 59, 62, 63, 78, 89, 90, 107, 108, 125, 126, 141, 157, 173, 187, 201: power LED.
- 4, 19, 28, 36, 48, 52, 144, 160, 176, 190, 204, 216, 223 : main body of the LEDs.
- 3, 35, 44, 47, 143, 159, 175, 189, 203, 215, 222: electrical terminals of the LEDs form the connection to the printed circuit.
- 5, 20, 29, 37, 49, 53, 161, 177, 191, 205, 217, 224: slugs of the LEDs designed to dissipate heat
- 2, 17, 26, 34, 43, 46, 50, 56, 59, 62, 142, 158, 174, 188, 202, 214, 221: lenses of the LEDs.
- 9, 22, 33, 42, 67, 82, 96, 114, 132, 148, 164, 180, 194, 208, 220, 228:
   heat sink devices (metal bodies).
- 6, 30, 38, 54, 57, 60, 64, 79, 91, 109, 127, 146, 162, 178, 192, 206, 218, 225, 226: standard laminates for the production of printed circuits
- 21: a special laminate with thermal substrate for assemblying electronic power devices by means of surface assemblying technology.
- 8, 32, 41, 66, 81, 94, 95, 112, 113, 130, 131, 147, 163, 179, 193 207, 219, 227: layers of insulating material (silicone material).
- 7, 31, 39, 65, 80, 92, 93, 99, 110, 111, 117, 128, 129, 151, 167, 183, 197, 211: flared holes.
- 13, 72, 75, 100, 118, 152, 168, 184, 198, calibrated spacing devices.
- 10, 68, 69, 97, 115, 149, 165, 181, 195, 209: threaded holes.
- 11, 70, 73, 98, 116, 150, 166, 182, 196, 210: lock screws.
- 14, 76, 105, 123, 137, 153, 169, 185, 199, 212: through-holes.
- 15, 77, 106, 124, 138, 154, 170, 186, 200, 213: wires supplying the control current.
- 85, 86, 104, 104, 121, 122, 135, 136: axes of any screw fasteners.
- 84, 102, 120, 134: cylindrical or prismatic wall surfaces.

With regard to the description above, it should be noted that in the case of conduction of heat between several surfaces/layers, the thermal path can be represented by a circuit with thermal resistances placed in series whereby the total thermal resistance is expressed by the sum of the individual resistances of the thermal path

To maximize the thermal transfer of the heat produced by the junction of the power LED, it is necessary either to reduce the thermal resistance values of the individual surfaces/ layers or to reduce the number of these in the junction-environment path

In this invention, the latter strategy has been adopted in order to reduce total thermal resistance as indicated in fig. 1 which highlights, vis-a-vis fig. 2, the absence of a laminate (laminate 21 of fig. 2) inserted between the slug 5 and the heat dispersion system 9, this being replaced by a single thin layer of silicone material 8 with the combined properties of electrical insulation and thermal conductibility.

In this way, minimization of the number of surfaces due to the single layer introduced, and to the minimum thickness and compensation of surface roughness (always present in the heat dispersion system 9), typical of the silicone material used, makes it possible to obtain high level thermal transfer

Such thermal transfer is difficult to obtain and involves high costs using the current technology in which there are a total of three layers inside the same laminate 21, thus requiring further measures to offset surface roughness in coupling to the heat dispersion system 22 and where, for reasons of manufacturing in surface mounting processes (remelt), the slug 20 of the power LED 16 is often fastened using an adhesive that, albeit with thermal characteristics, introduces another further layer/surface in the junction-environment thermal path.

Referring once again to fig. 1, in order to tighten and hold the slug 5 of the power LED 1 in position on the silicone layer 8, a hole 7 with upper flare is made in the laminate 6, for a standard type printed circuit, through which the primary lens 2 protrudes.

Tightness is maintained by the screw 11 that, through the flared hole 12 in the laminate 6 and through insertion of a calibrated spacer 13, promotes stable coupling to the heat dispersion system 9 by means of the threaded hole 10.

It should be noted that a single lock screw 11 is shown in fig. 1 insofar as this figure shows only the individual construction elements of the embodiment of the invention whereas, in the applications, the number of screws will be chosen sufficient to guarantee a balanced tightening of the power LEDs used. In some variants, there will be a reduced number of screws while, in others, there will be no screws as their function will be afforded by particular technical measures as described below.

Referring once again to fig. 1 the laminate 6 is, unlike the laminate 21 in fig. 2, of the standard low-cost type, widely used to produce printed circuits, for example but not exclusively of the FR4 type. Such laminate is also of the type with a single copper face facing towards the heat dispersion system 9 and in which the pads for soldering of the terminal 3 of the power LED 1 are engraved. In the same laminate there are also the pads necessary for connection to the drive power wires, one of which is indicated with 15 and which cross the heat dispersion system 9 with specific through-holes one of which is identified as 14.

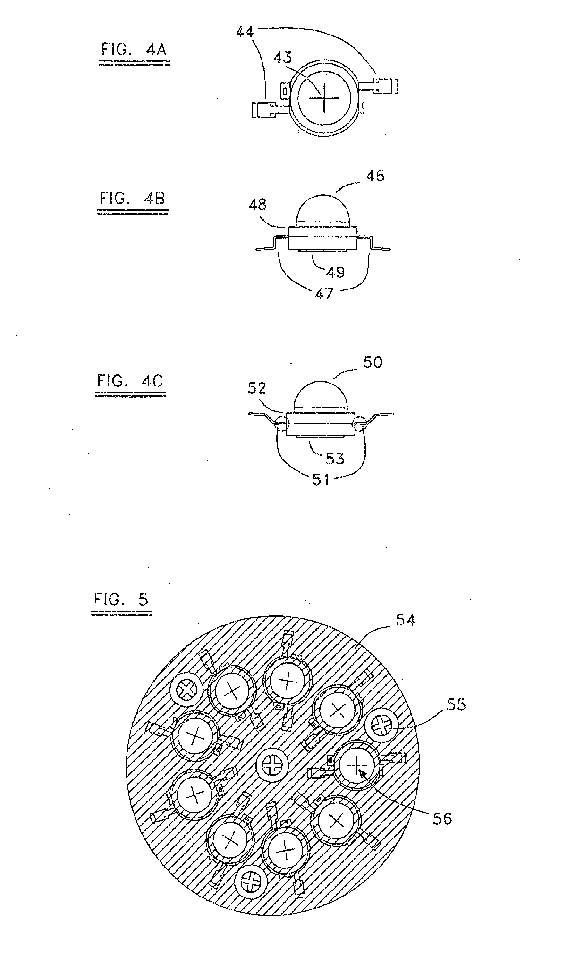

It should be noted that, to solder the terminals 3 of the power LED 1 to the pads provided in the laminate 6 above, prior additional preshaping of the terminals 3 is required modifying their original shape, shown in fig. 4B, in order to obtain the shape required, as shown in fig. 4C.

Additional preshaping will be carried out on specific machines designed for this purpose, using a two-phase process. In the first phase the terminals 51 of fig. 4C (3 in fig. 1) will be tightened close to the body 52 (4 in fig. 1) of the power LED as indicated in fig. 4C by the dotted circles.

In the second phase, the remaining part of the terminal will be shaped as shown in fig. 4C so that it touches the pads engraved in the laminate 6 once the lens 2 (50 in fig. 4C) of the power LED 1 has been inserted through the flared hole 7.

Figures 4B and 4C show a side view of the power LED before and after the additional preshaping; figure 4A is an upper view of the power LED in both situations. In the case illustrated in fig. 4A, the external lines indicate a slight increase in the overall dimensions of the terminals, to be taken into account when determining the dimensions/position of the solder pads on the laminate 6.

It must be considered however that, according to the type of power LED, the overall dimensions/positioning of the terminals may be the same or lower, compared with the situation prior to additional preshaping, according to the LED physical characteristics.

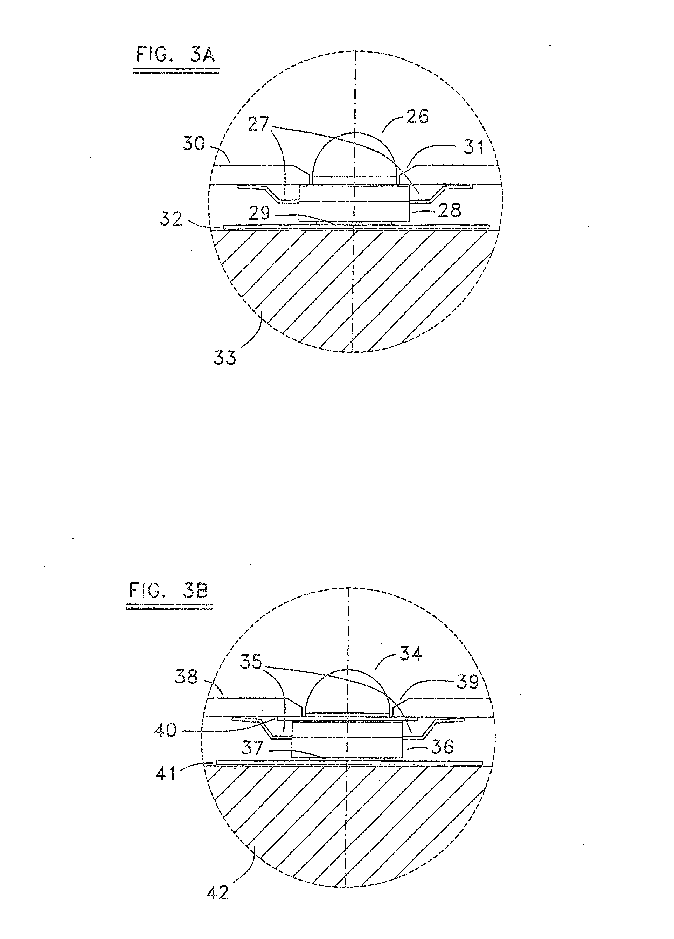

To highlight what has been indicated in fig. 1 for the power LED 1, fig. 3A shows an enlarged view of its components according to the mounting technology of this invention in its basic form, where the primary lens is indicated with 26, the main body with 28, the terminals with 27, the connection slug to the heat dispersion system with 29, the electrical insulation and thermal coupling silicone layer with 32, the heat dispersion system with 33 and the fastening laminate/connection pads with 30.

Fig. 3B shows a variant of the basic form of the invention in a view with the same degree of enlargement as fig. 3A. The variant consists in insertion of a thin elastomer washer 40 between the main body 36 and the fastening laminate 38 bearing the connection pads.

As an alternative to the elastomer washer, a thin layer of the same laminate 38 through which the primary lens 34 passes can be used for the element 4.

Addition of element 40 guarantees greater resistance to mechanical stress of the assembly mounted in particular as regards protection of the power LED in applications characterized by strong vibrations, as required in the case of products designed for the avionics and autonics sectors.

For a description of the other elements shown in fig. 3B, reference should be made to the corresponding elements in fig. 3A and fig. 1.

Compared with the state of the art illustrated in fig. 2 and according to the descriptions provided above and further detailed below, the invention in its basic form, illustrated in fig. 1 and fig. 3A or in the variant indicated in fig. 3B, makes it possible to achieve the following advantages:
- Minimization of junction/environment thermal resistance of the power LED.
- Possibility of assembly utilizing not only surface mounting automatic devices but also completely manual procedures using conventional soldering equipment, able therefore to satisfy small volume production requirements
- Protection of the primary lenses of the power LED during soldering.
- Easier reworking and repairs using ordinary equipment and normal skills.
- Electrical connections and parts protected and inaccessible once assembly has been completed, thereby guaranteeing compatibility with electrical safety requirements in applications in which secondary optics are not used.
- Reduction of the total space required (in height) for the heat dispersion system, important for insertion in frames or containers (where such requirement is demanded) and equal to approx. the thickness of the laminates used (at least one millimeter less).
- No problem of adaptation of the thermal expansion coefficient of the materials used due to the use of layers of materials with elastomer properties.
- Elimination of the use of adhesives in manufacturing processes.
- Improved resistance to vibrations, in particular in case of applications characterized by large masses of the heat dispersion system.
- Reflecting/diffusion surface adjacent to the emission surface of the light flux of the power LED completely uniform and white, black or of the color required by the application.

Figure 5, 6 and 7 are upper views of devices implementing the preferred embodiment of figures 1, 3A or of the variant in figure 3B in which configurations of power LEDs 56, 59, 62 that differ according to color, number and geometric positioning makes it possible to obtain different flows of light according to different application requirements.

The views show, in transparency, the main body and the terminals of the power LED 56, 59 and 62 located below laminates 54, 57 and 60 (indicated with a dotted line) in which the flare of the holes (detail 7 of fig. 1) has not been shown in order to permit a more clear representation.

It should be noted that such figures represent only examples, as many different combinations of colors, number of power LEDs used and positioning are possible.

In particular, other outline shapes of the fastening laminates and terminal connection pads will be possible, different from those indicated with 54, 57 and 60 in the above-mentioned figures, in order to adapt them to the containers and heat dispersion systems present in the final application in which the invention is used.

Referring once again to the aforementioned figures, the elements indicated with 55, 58 and 61 identify lock screws for fastening laminates 54, 57 and 60 in position, as described previously for figure 1, liable to variants in particular as regards their number in order to balanced tightening; the screws may also be absent insofar as their function is performed by alternative technical measures.

If screws are used, It should be noted that these will preferably be of the flared head type (as indicated in fig. 1) and also of the same color (to guarantee continuity of the reflecting/diffusion surface of the laminates 54, 57, 60), through painting or additional electro-plating processes.

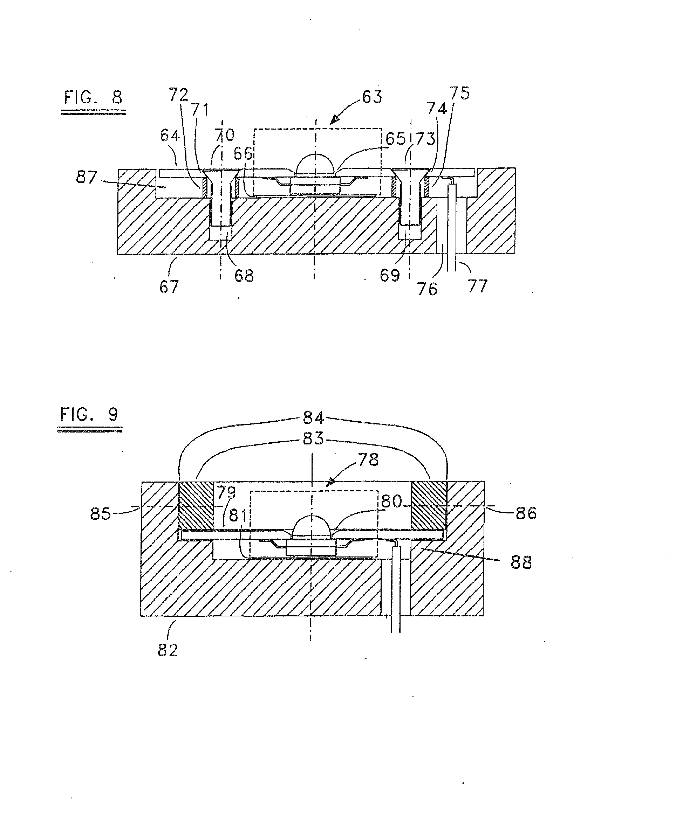

Figure 8 is a partial section view of an embodiment of the invention of figure 1, 3A or of the variant in figure 3B in which the power LED 63 is inserted in the flared hole 65 of the laminate 64 and pressed on the heat dispersion system 67 with insertion of a layer of silicone material 66, by means of lock screws 70, 73 present in flared holes 71, 74 of the laminate 64, threaded holes 68, 69 in the heat dispersion system 67 and calibrated spacers 72, 75.

The same figure shows the through-hole or cavity 76 (through which the conducting wire with insulating sheath 77 is inserted) interconnected to the related copper pad on the lower side of the laminate 64 by means of direct soldering or connectors.

Similarly, another hole or cavity will be provided for insertion of a second conductor in order to interconnect the power LED with the power drive system. Alternatively such conductors may be grouped in a single through-hole or cavity.

Similarly, other screws, flared holes to house these on the laminate 64, threaded housings in the heat dispersion system 67, calibrated spacers, layers of silicone, power LEDs, through-holes or cavities for insertion of other conductors in the heat dispersion system 67 and related conductors may be present in further embodiments directly derived from that illustrated in figure 8 in order to improve emission of the light flux, for example in the non-exclusive ways indicated in figures 5, 6, 7.

Referring once again to figure 8, it should be noted the particular upper shape of the heat dispersion system 67 which forms a recess 87 large enough to contain the assembled elements of this invention as described previously and closed more or less perfectly by the fastening laminate/lead pads 64.

Although such upper shaping of the heat dispersion system 67 in relation to the laminate 64 is not strictly necessary for implementation of the embodiment illustrated in figure 8, the same is however preferable in order to protect the leads in the case of use in applications that do not envisage secondary optics.

It should also be noted that the remaining conformation of the heat dispersion system 67 shown in fig. 8 is only the simplest of the many possible representations according to different application requirements; in particular, finned surfaces may be used in order to further minimize the junction/environment thermal resistance of the power LED and/or other metal bodies may be inserted, intended to expand the heat dispersion system (for example, tubular or square/rectangular section elements with smooth/finned surface according to the characteristics of the element 67, shown only in section).

With regard to the heat dispersion system 67 of figure 8, the upper outer edges may be shaped in different ways in order to secure secondary optics (additional lenses/reflectors).

Alternatively, such additional optical elements may also be fastened on the aforementioned metal bodies that extend the heat dispersion system 67

Lastly, in final applications, the heat dispersion system 67 or the metal extension bodies of this may be fastened to the basic supports/ bodies of the solid state lights sources using diaphragms made of materials with low thermal conductivity so that the heat transmitted or produced by these does not impair the efficiency of the heat dispersion system 67.

Figure 9 is a partial section view of an embodiment of the invention which differs from that shown in figure 8 and described previously insofar as there are not present screws for locking the fastening laminate/lead pads 79 in position.

To this end, the heat dispersion system 82 is characterized by a step 88 on the wall of the cavity designed to permit insertion of a mechanical fastener 83 which holds the laminate 79 in place.

The heat dispersion system 82 and the mechanical fastener 83 may be coupled through threading of the parts along the surfaces indicated with 84 in the case of cylindrical and co-axial parts, or alternatively they may be coupled by a snap-in mechanism.

As a further alternative, coupling may be afforded by a screw fastener inserted along the axes indicated with 85 and 86 in case this also serves to connect the heat dispersion system 82 to metal elements extending the same. The same alternative can be adopted if it makes it possible to minimize the total number of screws used to tighten the laminate 79, compared with the number of screws required for the system indicated in figure 8, where e great number of power LEDs is present.

For the remaining parts indicated in figure 9, reference should be made to the description of the corresponding parts of figure 8 and the related general remarks

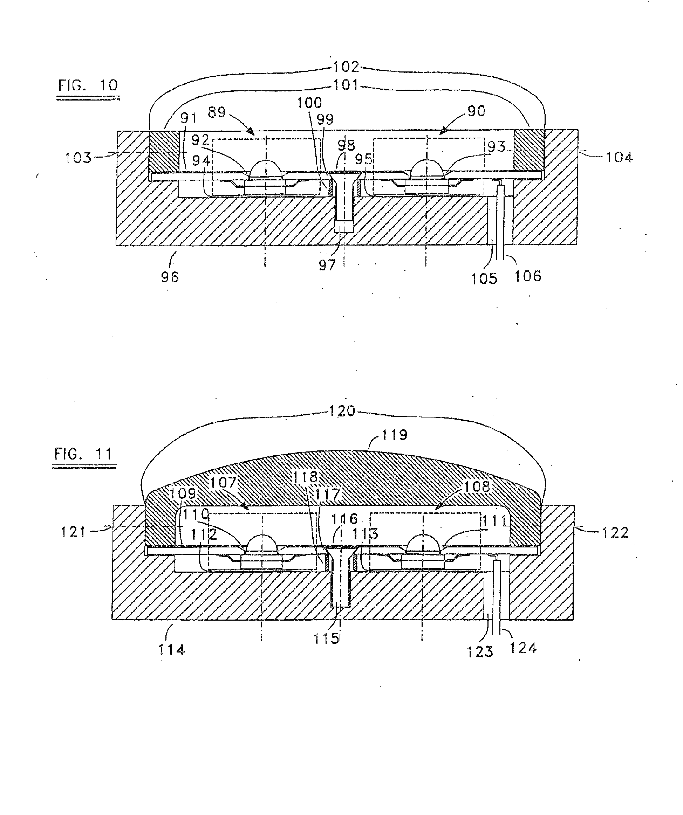

Figure 10 is a partial section view of an embodiment of the invention that differs from those indicated in figures 8 and 9 above as regards the method of fastening laminate 91 bearing the terminal pads.

Such method of fastening is to be combined with the methods used in the embodiments of the invention illustrated in figures 8 and 9; for the matching parts, reference should be made to the related description and general remarks.

Figure 11 is a partial section view of an embodiment of the invention that differs from that shown in figure 10 described previously with regard to the method of clamping in position the fastening laminate (and teminal pads) 109.

Such method of clamping has been implemented using a secondary optical device 119 instead of the mechanical fastener 101 of figure 10 insofar as the parts intended to couple with the heat dispersion system 114 are of equivalent geometrical shape.

For the remaining parts indicated in figure 11, reference should be made to the description of the corresponding parts of figure 10 and also to the related general remarks.

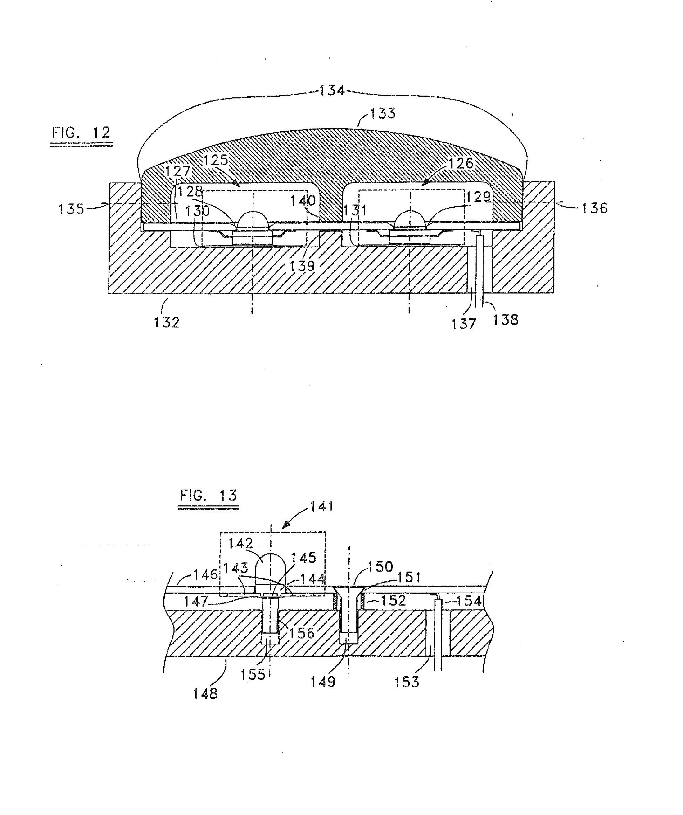

Figure 12 is a partial section view of an embodiment of the invention that differs from that shown in figure 11 described previously due to the complete absence of lock screws at the position of the fastening laminate/lead pads 127, and that can be implemented regardless of the number of power LED used and their geometrical layout in the laminate.

Even the embodiment of figure 9 makes it possible to set up systems with multiple LEDs but arranged so as to comply with the layout indicated in the figure or, for example, arranged in a single row for insertion in a bar.

On the other hand, the embodiment of figure 12 makes it possible to keep the laminate 127 in place regardless of how the power LEDs are arranged, preventing sagging of the laminate due to the presence of the protrusion 139 in the heat dispersion system 132 and of the protrusion 140 in the secondary optical device 133.

It should be noted that further embodiments will be directly derived from that shown in figure 12 according to the number of power LEDs and their geometrical arrangement in the laminate 127.

For the remaining parts indicated in figure 12, reference should be made to the description of the corresponding parts of figure 11 and also to the related general remarks

The embodiment of figure 13 makes it possible to adopt the innovative principle illustrated in figure 1 and in the other figures (with its the advantages) for certain particular power LEDs 141, consisting of a primary lens 142 fitted at the top of a main body 144 with two terminals 143 protruding from the side, of the rigid, flat-shaped, non-folding type and, at the bottom, a slug 145 positioned at the center of the body and aligned with the terminals.

The difference in relation to the embodiment of figure 1 lies in the method of connection of the slug of the power LED to the heat dispersion system, afforded by a bolt 156 with a head of a diameter equal to that of the slug itself, inserted in a specific housing 155 and insulated by a layer of silicone 147.

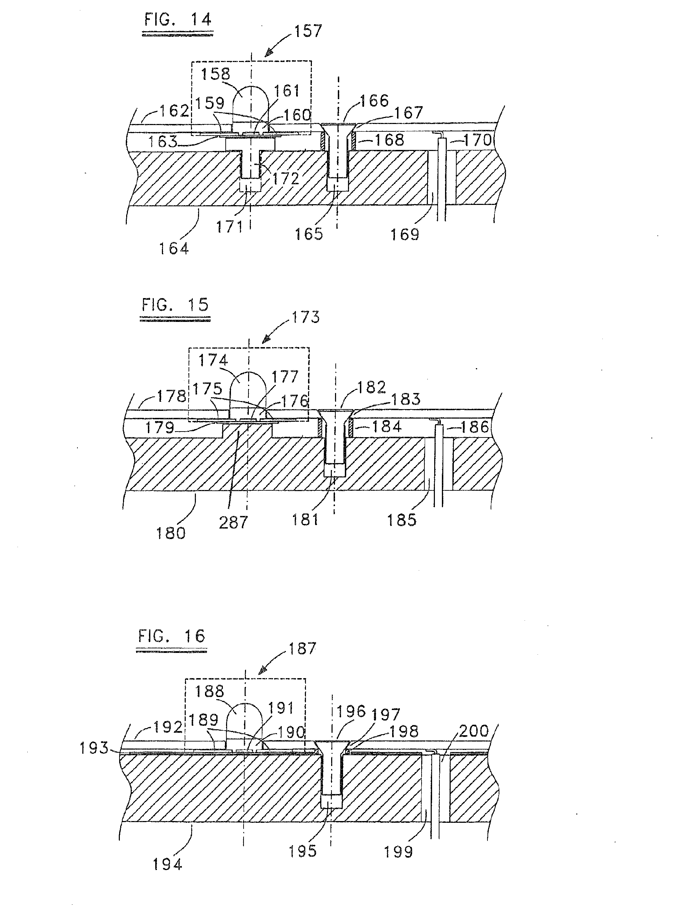

The embodiment of figure 14 is a variant of the solution indicated in figure 13 in which the bolt 172 has a head with a larger diameter than the slug 161 of the power LED 157 in order to improve thermal transfer and mechanical stability especially in the case of smaller sized slugs.

It should be noted that the layer of silicone material 163 insulates not only the slug but also the terminals 159 of the power LED from the heat dispersion system.

The embodiment of figure 15 is a further variant of the solution illustrated in figures 13 and 14 in which the bolt is replaced by a protrusion 287 of the heat dispersion system 180.

The embodiment of figure 16 implements the solution illustrated in figures 13, 14 and 15 and in related descriptions. In such implementation the slug 191 and the terminals 189 of the power LED 187 are positioned on a flat face of a heat dispersion system 194 simply inserting a layer of silicone 193.

In order to implement this embodiment, the solder of the terminals 189 on the printed circuit 192 must be applied so as to englobe the terminals for a height not less than their thickness in order to guarantee correct thermal coupling between the parts after tightening of the printed circuit on the heat dispersion system with the screw 196.

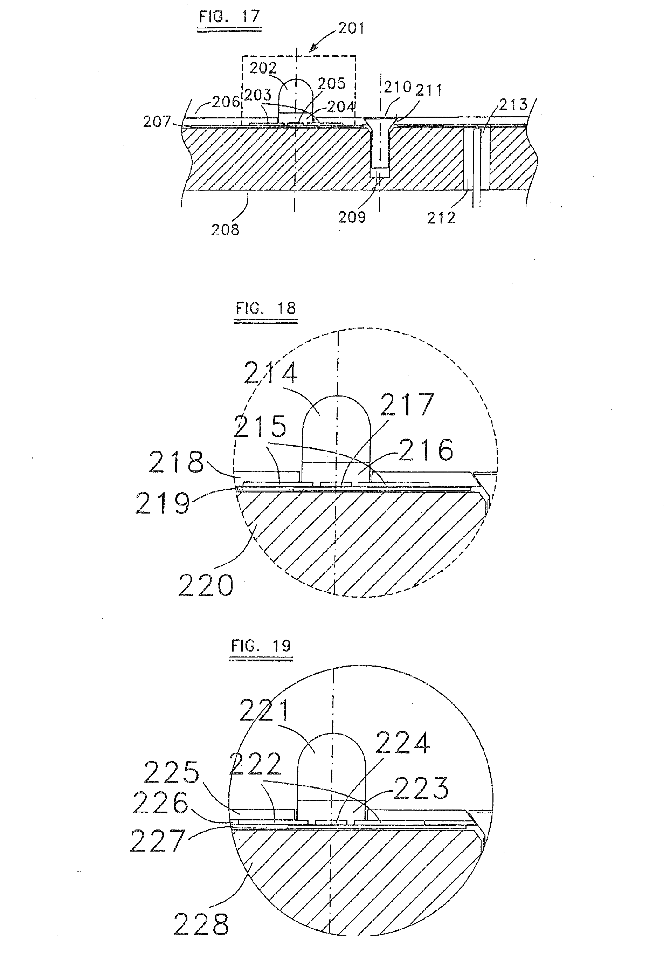

The embodiment of figure 17 implements the solution indicated in figure 13 and related descriptions in which the terminals 203 of the power LED 201 are housed, for almost their entire thickness, in a metallic housing in the laminate 206.

Such housing can be seen more clearly in figure 18 which shows a detail of figure 17 in which the laminate is identified as 218 and the terminals as 215.

A variant of the embodiment illustrated in figures 17 and 18 is shown in figure 19 in which the laminate used previously is replaced by two coupled laminates 225 and 226 in order to form the metallic housing for the terminals 222 in an alternative fashion.

The two laminates may be coupled using different technologies, for example using known technologies for the manufacture of multilayer printed circuits.

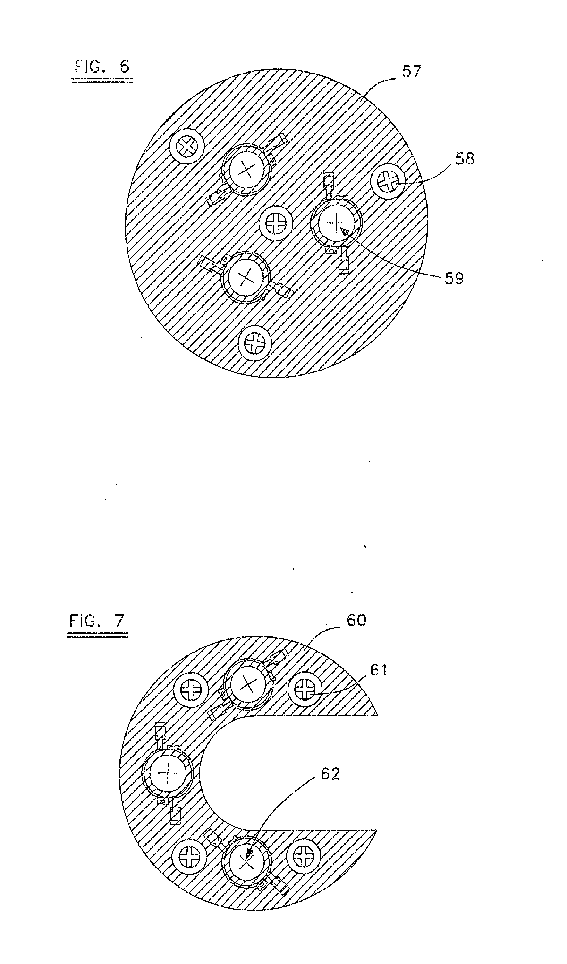

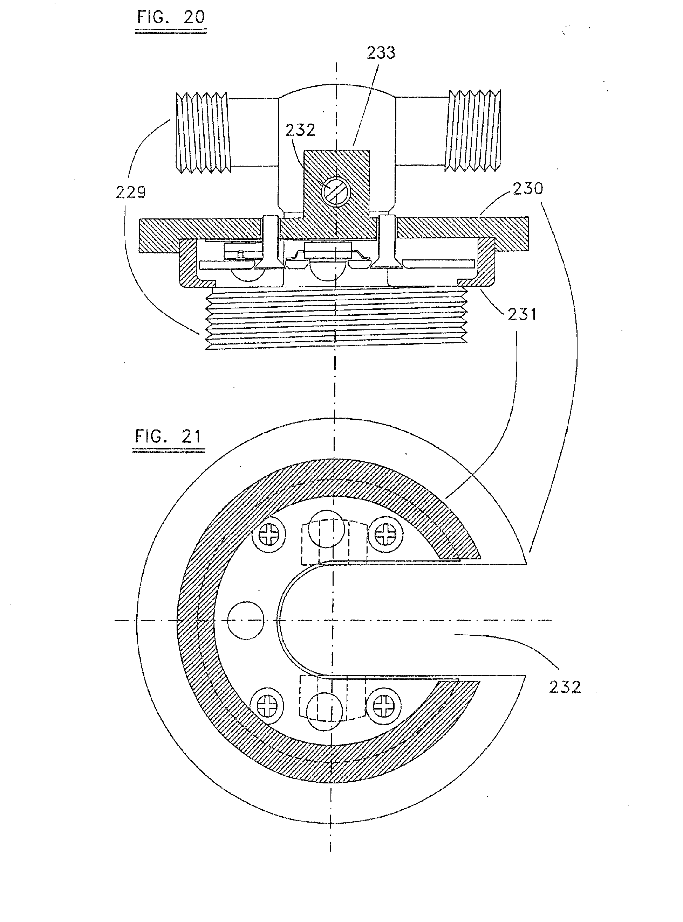

Figures 20 and 21 show a possible embodiment of the invention regarding the shape of the fastening laminate 60 illustrated in figure 7 for the purpose of creating a complete lighting body for illumination of transparent and/or light-diffusing manufactured items.

In particular, figure 13 is a partial section view of the device complete with its main parts while figure 14 is a view of the light emission side of the power LED not comprising the manufactured item 229. It should be noted that, for the remaining parts not identified by numeric references or not represented, the previous descriptions and illustrations apply.

The manufactured item of light transmitting material to be illuminated is identified with 229, whereas 230 indicates the heat dispersion system shaped so as to permit insertion through a grove 233 opened in the manufactured item 229 in cases in which this characteristic is required for coupling of parts using lock screws 232.

An element 231 is inserted between the manufactured item 229 and the heat dispersion system 230 to permit mechanical stabilization and/or to create an optical reflection/diffusion chamber.

Naturally numerous modifications, adaptations, variants and replacements of members with others functionally equivalent can be made to the embodiments described above by way of example without going beyond the spirit of the invention and the scope of the claims set forth below.

## Claims

1. Power led lighting or light signaling device of the type comprising:
- a laminate (6, 30, 38, 54, 57, 60, 64, 79, 91, 109, 127) with a printed circuit_{;}
- at least one power LED (1, 16, 56, 59, 62, 63, 78, 89, 90, 107, 108, 125, 126) comprising a main body (4, 144) with two electrical terminal (3, 35, 44, 47) protruding from this, connected to such printed circuit,
and with a slug (5, 20, 29, 37,49, 53) on one side acting as heat sink
for dispersion of heat;
- a HEAT SINK metallic body (9, 22, 33, 42, 67, 82, 96, 114, 132) where such slug is connected indirectly in order to permit such dispersion of heat, such metallic body having a flat face parallel and opposed to such laminate and on which the laminate is fastened; wherein:
- the LED is not outside the laminate of the printed circuit but is inserted in the same through a hole (7, 31, 39, 65, 80, 92, 93, 110, 111, 128, 129) present in the printed circuit;
- the aforesaid face is covered, at least at a position opposite to the aforesaid LED, by a thin layar (3, 32, 41, f6, 61, 94, 95, 112, 113, 130, 131) of insulating material in contact with such slug, to assure not only electrical insulation but also thermal coupling with the slug;
- the edges of such hole, pressing on the body of the LED, maintain the
aforesaid slug in contact with such thin layer of insulating material, **characterized by** further comprising:
- at least a means of spacing (13) **extending** between the laminate with the printed circuit and the flat face in order to assure positioning of the laminate at pre-established distance from **the flat face**, wherein the at least one means of spacing protrudes from the laminate and/or from the flat face;
- a plurality of through-holes (14, 76, 105, 123, 137) extending across the thickness of the metallic body (9, 22, 33, 42, 67, 82, 96, 114, 132);
- a plurality of power wires interconnected to the lower side of the laminate (6, 30, 38, 54, 57, 60, 64, 79, 91, 109, 127) with a printed circuit, wherein each power-wire passes through a respective through-hole (14, 76, 105, 123, 137), protrudes out of the metallic body on the outer side thereof opposite to the laminate (6, 30, 38, 54, 57, 60, 64, 79, 91, 109, 127) with a printed circuit and is electrically isolated from the metallic body (9, 22, 33, 42, 67, 82, 96, 114, 132).

2. Lighting or light signaling device as per Claim 1 **characterized by** the fact that the material forming the aforesaid thin layer of insulating material is a silicone material.

3. Lighting or light signaling device as per Claim 1 **characterized by** the fact that the aforesaid edges of such hole press on the body of the LED via a washer (40).

4. Lighting or light signaling device as per Claim 1 **characterized by** the fact that the aforesaid flat face forms the bottom of a recess (87) realized in said metallic body.

5. Lighting or light signaling device as per Claim 4 **characterized by** the fact that a step (88) in the walls of such recess is used as the aforesaid means of spacing.

6. Lighting or light signaling device as per Claim 4 **characterized by** the fact that a protrusion (139) on the bottom of such recess is used as aforesaid means of spacing.

7. Lighting or light signaling device as per Claim 1 **characterized by** the fact that, in an intermediate section of the two aforesaid terminals of the power LED, there is a fold such as to permit connection of the end of each lead with the printed circuit.

8. Lighting or signaling device as per Claim 1, **characterised in that** the the laminate is substantially flat.

9. Lighting or signaling device as per Claim 1, **characterised in that** the hole (7, 31, 39, 65) through which the LED is inserted is flared.
